# EUROPÄISCHE PATENTSCHRIFT

(11) **EP 2 077 340 B1**
(45) Veröffentlichungstag und Bekanntmachung des Hinweises auf die Patenterteilung: **09.10.2013**
(21) Anmeldenummer: 08167060.6
(22) Anmeldetag: 20.10.2008
(51) Int. Cl.: C23C 14/50

(54) **Verfahren und Vorrichtung zum Beschichten von Gläsern**
Method and device for coating glasses
Procédé et dispositif destinés au revêtement de verres

(30) Priorität: 22.12.2007 DE 102007062618
(43) Veröffentlichungstag der Anmeldung: 08.07.2009
(73) Patentinhaber: Carl Zeiss Vision GmbH, 73430 Aalen (DE)
(72) Erfinder: Littek, Martin, 71404 Korb-Kleinheppach (DE); Dangelmaier, Andreas, 89522, Heidenheim (DE); Meschenmoser, Ralf, 73434, Dewangen (DE)
(74) Vertreter: Carl Zeiss AG - Patentabteilung

(56) Entgegenhaltungen:
- EP-A- 0 406 483
- EP-A- 0 806 492
- EP-A- 1 835 048
- DE-U1- 29 510 613
- JP-A- 60 224 777
- US-A- 3 396 696

## Beschreibung

### GEBIET DER ERFINDUNG

Die vorliegende Erfindung betrifft eine Vorrichtung zur Beschichtung von Glas in einer Vakuumkammer mit einem Gestell zur Lagerung einer Vielzahl von zu beschichtenden Gläsern, wobei das Gestell eine vorzugsweise gekrümmte Lagerfläche mit einer Vielzahl von Aufnahmen aufweist, in welchen die Gläser während der Beschichtung aufgenommen werden können. Die Beschichtung betrifft weiterhin ein Verfahren zum Beschichten von Glas in einer Vakuumkammer unter Verwendung einer derartigen Vorrichtung.

### STAND DER TECHNIK

Für die Herstellung von Brillengläsern ist es erforderlich, die Brillengläser mit einer Antireflexionsschicht zu versehen. Diese Antireflexionsschicht wird in einer Vakuumkammer durch Elektronenstrahlverdampfen des Beschichtungsmaterials durchgeführt. Dabei ist eine Vielzahl von Brillengläsern auf einer sog. Kalotte angeordnet, die sich innerhalb der Vakuumkammer dreht, um eine gleichmäßige Ablagerung des verdampften Beschichtungsmaterials auf den Brillengläsern zu gewährleisten. Die Kalotte definiert hierzu eine üblicherweise halbkugelförmige Lagerfläche, auf der die zu beschichtenden Brillengläser angeordnet sind. Die Brillengläser werden hierzu in entsprechenden Aufnahmen der Lagerfläche eingesetzt. Dies erfolgt außerhalb der Vakuumkammer, so dass die Kalotte in mehrere Kalottenteile unterteilt ist, die lösbar auf einem Gestell angeordnet werden können. Zum Beschicken der Aufnahmen eines Kalottenteils wird das Kalottenteil aus der Vakuumkammer entfernt und mit den Gläsern bestückt und anschließend auf dem drehbaren Gestell in der Vakuumkammer mit den aufgenommenen Brillengläsern abgelegt.

Die DE 295 10 613 U1 beschreibt eine Haltevorrichtung für in einer Vakuumbeschichtungsanlage zu behandelnde Substrate bestehend aus einem in der Prozesskammer angeordneten Rahmen oder einer Platte mit mehreren am Rahmen oder an der Platte befestigbaren Substrathaltern, von denen jeder mindestens ein Substrat aufnimmt.

Aus der EP 0 806 492 A1, von der die Erfindung ausgeht, ist ein Substrat-Träger in Form einer kalottenförmigen Platte bekannt, die in drei Abschnitte durch Gelenkmittel unterteilt ist, wobei der mittlere Abschnitt Mittel zur Aufnahme von drei nebeneinander liegenden Substraten aufweist.

Um eine Beschichtung auf beiden Seiten des Brillenglases vornehmen zu können, müssen die Brillengläser nach dem Aufbringen einer ersten Beschichtung auf der ersten Seite gewendet werden, um auf der zweiten Seite ebenfalls eine Beschichtung aufbringen zu können. Das Wenden erfordert einen hohen Aufwand, da der Beschichtungsprozess unterbrochen, die Kalottenteile aus der Vakuumkammer entfernt und die Gläser gewendet werden müssen.

Ein automatisiertes Wenden der Gläser innerhalb der Vakuumkammer scheitert meist an dem hohen Aufwand für entsprechende Wendemechanismen, die für eine Vielzahl von Brillenglasaufnahmen vorgesehen werden müssen.

Die EP 0 406 483 A2 offenbart z.B. eine Vorrichtung zum Halten und Wenden von Linsen, insbesondere für in einer Hochvakuum-Aufdampfanlage oder -Sputteranlage zu beschichtende Brillenglaslinsen.

Es ergibt sich das Problem, dass die Wendemechanismen in der Beschichtungskammer während der Beschichtung zumindest zum Teil verbleiben müssen, so dass sie ebenfalls der Beschichtung ausgesetzt sind. Dies kann entsprechend leicht zu einem Ausfall eines Wendemechanismus führen oder der Wendemechanismus muss entsprechend oft gereinigt werden, was wiederum einen hohen Aufwand bedeutet, da eine Vielzahl von Kalottenteilen mit entsprechenden Aufnahmen vorgesehen werden müssen, um einen vernünftigen Betrieb aufrecht erhalten zu können.

### OFFENBARUNG DER ERFINDUNG

### AUFGABE DER ERFINDUNG

Es ist deshalb Aufgabe der vorliegenden Erfindung, eine Vorrichtung und ein Verfahren zur Beschichtung von Glas in einer Vakuumkammer bereitzustellen, bei dem der Beschichtungsprozess effektiver gestaltet werden kann und insbesondere ein Wenden des Glases in der Vakuumkammer möglich wird. Gleichzeitig soll die entsprechende Vorrichtung einfach aufgebaut und das Verfahren einfach durchführbar sein.

### TECHNISCHE LÖSUNG

Diese Aufgabe wird gelöst durch eine Vorrichtung mit den Merkmalen des Anspruchs 1 und ein Verfahren mit den Merkmalen des Anspruchs 25. Vorteilhafte Ausgestaltungen sind Gegenstand der abhängigen Ansprüche.

Die Erfindung geht aus von der Erkenntnis, dass eine automatische Wendeeinrichtung für Brillengläser in einer Vakuumbeschichtungsanlage dann realisiert werden kann, wenn die Aufnahmen für die Brillengläser und die dort angeordnete Wendeeinrichtung nicht mehr in größeren Kalottenteilen zusammengefasst sind, sondern einzeln austauschbar sind, da dadurch eine höhere Effektivität hinsichtlich des Einsatzes der Vorrichtung erzielt werden kann. Bei einer Beschichtung des Wendemechanismus und einer dadurch erforderlichen Reinigung kann nämlich ein einzelnes Fragment mit einer oder einigen wenigen Aufnahmen ausgewechselt werden, um eine Reinigung durchzuführen. Damit kann die Gesamtanzahl der vorrätig zu haltenden Aufnahmevorrichtungen niedrig gehalten werden. Da gleichzeitig für eine effektive Beschichtung jedoch eine möglichst große Anzahl von Brillengläsern auf dem Gestell angeordnet werden soll, ist die Unterteilung der Lagerfläche bzw. der Kalotte in ungleichmäßig geformte Fragmente vorteilhaft, da dadurch eine dichte Packung an Aufnahmen erzielt werden kann. Außerdem wird dadurch die Stabilität der aus den vielen Fragmenten zusammengesetzten Lagerfläche erhöht. Vorteilhaft ist es insbesondere, für jede Aufnahme ein einzelnes Fragment vorzusehen, so dass die Aufnahmen bzw. Fragmente einzeln austauschbar in dem Gestell aufgenommen sind.

Entsprechend ist es nach einem zweiten Aspekt, für den im Zusammenhang mit dem ersten Aspekt Schutz begehrt wird, möglich, einen automatisierten Wendemechanismus für die Brillengläser vorzusehen, da bei einem möglichen Ausfall eines Wendemechanismus lediglich dieser ausgetauscht werden muss und nicht eine Vielzahl von anderen auf dem gleichen Kalottenteil angeordneten Wendemechanismen.

Darüber hinaus kann der Wendemechanismus so ausgebildet sein, dass dieser zentral für alle Aufnahmen gleichzeitig schaltbar ist, so dass der Aufwand für die Schaltung der einzelnen Wendemechanismen verringert werden kann.

Insbesondere kann der Wendemechanismus einen Aktuator aufweisen, der durch Temperaturänderung betätigbar ist, so dass auf eine Verkabelung mit Steuer- und Befehlsverbindungen sowie Energieversorgungsleitungen verzichtet werden kann.

Hierzu kann der Aktuator eine Formgedächtnislegierung umfassen, welche durch Temperaturänderung eine Formänderung erfährt und somit eine Bewegung durchführen kann.

Insbesondere kann der Aktuator in Form eines Elements ausgebildet sein, das sich linear ausweitet oder verlängert bzw. wieder verkürzt, etwa in der Art einer Zugfeder oder eines Hubzylinders.

Zur zentralen und/oder gemeinsamen Schaltung der Aktuatoren kann eine Heiz- und/oder Kühleinrichtung zentral in der Vakuumkammer für die Betätigung aller Aktuatoren vorgesehen sein. Vorteilhafterweise können jedoch auch mehrere Heiz- und/oder Kühlvorrichtungen vorhanden sein, um eine gleichmäßige Temperaturverteilung in der Vakuumkammer zu erzielen. Für die Heizung bieten sich in der Vakuumkammer insbesondere Strahlungsheizgeräte an.

Der Aktuator aus der Formgedächtnislegierung kann als selbstständiges Antriebsmittel fungieren, wobei die Bewegung oder Formänderung der Aktuatoren eine entsprechende Bewegung des Wendemechanismus umgesetzt wird. Dies kann beispielsweise über ein Kipphebelgetriebe erfolgen.

Andererseits ist es auch denkbar, den Aktuator lediglich als Schaltelement für ein Antriebsmittel, beispielsweise für ein energiespeicherndes Antriebsmittel wie eine Feder, vorzusehen, so dass durch den Aktuator das eigentliche Antriebsmittel, wie zum Beispiel eine vorgespannte Feder, betätigt wird.

Bei Verwendung eines Kipphebelgetriebes kann das Getriebe eine Umsetzung der Kippbewegung des Kipphebels in eine Drehbewegung der Glas-Aufnahme bewirken, wobei eine entsprechende Übersetzung gewählt werden kann, so dass eine geringe Kippbewegung in eine ausreichend große Drehbewegung umgesetzt wird.

Bei einem Kipphebelgetriebe kann sich zudem als vorteilhaft erweisen, einen Freilauf vorzusehen, der die Bewegungsrichtung des Aktuators nur in einer Richtung umsetzt, aber in der Gegenrichtung keine Betätigung verursacht. So kann beispielsweise eine Längendehnung des Aktuators bei Temperaturanstieg eine entsprechende Drehbewegung des in der Aufnahme aufgenommenen Glases verursachen, während eine Verkürzung des Aktuators bei einer Absenkung der Temperatur ohne Wirkung auf die Aufnahme bzw. das Glas bleibt.

Um das Kipphebelgetriebe vor der Beschichtung zu schützen bzw. zu vermeiden, dass das Vakuum der Vakuumkammer durch Abrieb oder dergleichen verschmutzt wird, kann das Kipphebelgetriebe zumindest teilweise gekapselt ausgeführt sein. Insbesondere kann das Kipphebelgetriebe schmiermittelfrei gestaltet sein oder lediglich Komponenten verwenden, die einen geringen Abrieb erzeugen, beispielsweise durch gegenseitige Rollbewegung, wohingegen Schiebebewegungen oder Gleitbewegungen vermieden werden. Das Kipphebelgetriebe kann auch austauschbar an dem Fragment oder der Aufnahme angeordnet sein, so dass ein Austausch unabhängig von der fragmentierten Lagerfläche möglich ist. Aufgrund der einfacheren technischen Realisierbarkeit wird jedoch ein Austausch der Fragmente bevorzugt.

Das Kipphebelgetriebe kann in einfacher und effektiver Weise durch Keramik- und/oder Metallpulver-Spritzgießen hergestellt werden.

Die Aufnahme kann weiterhin einen Spannmechanismus zum klemmenden Halten eines Glases aufweisen, welcher ein schnelles Einbringen und Entfernen des Glases ermöglicht.

Auch der Spannmechanismus kann lösbar in die Aufnahme oder das Fragment bzw. das Kipphebelgetriebe einsetzbar sein. Dies erleichtert die Anordnung des Glases, da der Spannmechanismus zum Halten des Glases unabhängig von dem Fragment bzw. der Aufnahme an dem Glas angeordnet werden kann.

Eine entsprechende Vorrichtung kann so betrieben werden, dass zum Schalten des Wendemechanismus die Temperatur in der Vakuumkammer auf eine bestimmte Schalttemperatur angehoben wird, die über der höchsten Prozesstemperatur, die in der Kammer ansonsten für den Beschichtungsprozess erreicht wird, gesetzt ist. Durch zentrales bzw. gemeinsames Aufheizen des Wendemechanismus auf die entsprechende Schalttemperatur können alle Wendemechanismen für alle Aufnahmen gleichzeitig geschaltet werden und zwar ohne großen Aufwand für entsprechende Steuer- und Energieversorgungsverbindungen. Üblicherweise wird die Schalttemperatur ausreichend hoch gewählt, also mit einem Abstand zur höchsten Prozesstemperatur, beispielsweise in der Größenordnung von 10 Kelvin oder darüber.

Da beim Zurücksetzen des Formgedächtnis-Aktuators eine Hysterese auftritt, muss die Schaltung in umgekehrter Richtung bei einer niedrigeren Schalttemperatur vorgenommen werden.

### KURZBESCHREIBUNG DER FIGUREN

Weitere Vorteile, Kennzeichen und Merkmale der vorliegenden Erfindung werden bei der nachfolgenden detaillierten Beschreibung eines Ausführungsbeispiels anhand der beigefügten Zeichnungen deutlich. Die Zeichnungen zeigen hierbei in rein schematischer Weise in
- Figur 1: eine Seitenansicht einer Vakuumbeschichtungsanlage;
- Figur 2: eine Detailansicht des Gestells zur Aufnahme der zu beschichtenden Gläser der Vakuumbeschichtungsanlage aus Figur 1; und in
- Figur 3: eine Detailansicht der Wirkungsweise eines Kipphebelgetriebes.

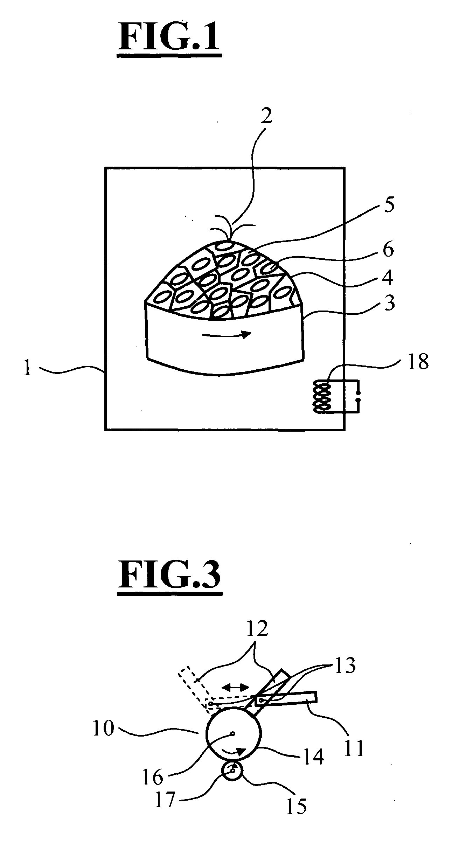

Die Figur 1 zeigt in einer rein schematischen Darstellung eine Seitenansicht einer Vakuumbeschichtungsanlage für die Beschichtung von Gläsern, insbesondere Brillengläsern, die beispielsweise mit einer Antireflexionsschicht versehen werden.

Hierzu ist eine Vakuumkammer 1 vorgesehen, in welcher drehbar ein Gestell 3 aufgenommen ist, welches eine kugelkalottenförmige Lagerfläche 4 aufweist, an deren oberen Scheitelpunkt eine Öffnung für eine Verdampferquelle 2 vorgesehen ist. Auf der kalottenförmigen Lagerfläche 4 sind eine Vielzahl von Aufnahmen 6 für die Aufnahme von Brillengläsern vorgesehen, auf denen sich das von der Verdampferquelle 2 abgeschiedene Beschichtungsmaterial ablagern kann. Hierbei dreht sich das Gestell 3 entsprechend dem Pfeil um die eigene Achse, so dass eine gleichmäßige Beschichtung der in den Aufnahmen 6 aufgenommenen Brillengläser erfolgt.

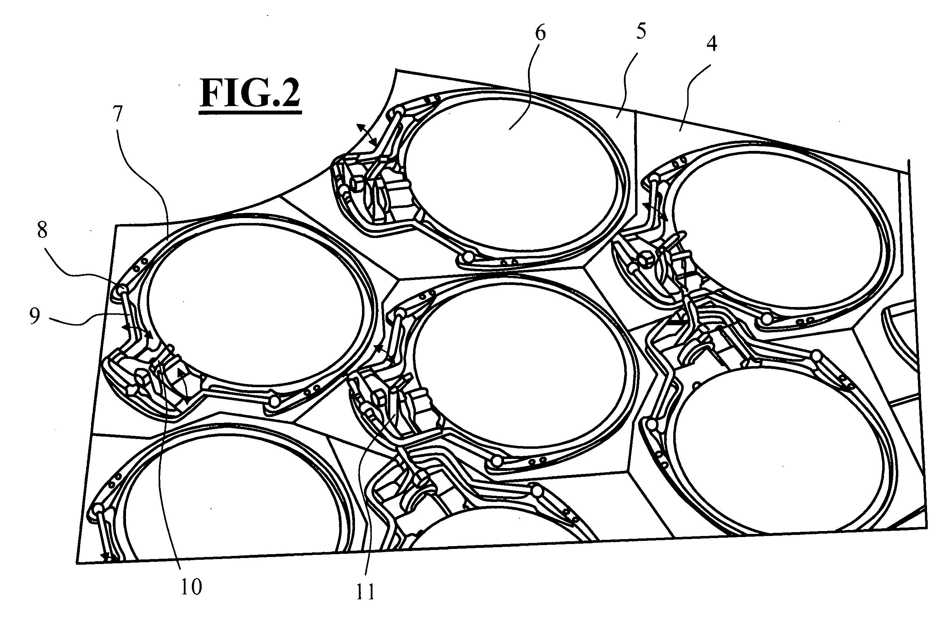

Die kalottenförmige Lagerfläche 4 ist unterteilt in eine Vielzahl von Fragmenten 5, denen jeweils eine Aufnahme 6 zugeordnet ist. Durch die Unterteilung der kalottenförmigen Lagerfläche 4 in eine Vielzahl von Fragmenten 5 ist ein einfacher Austausch einzelner Aufnahmen 6 möglich. Durch die in Figur 1 angedeutete und in Figur 2 in der Detailansicht der Lagerfläche 4 deutlicher zu sehende mehreckige Form der Fragmente 5 ist eine optimale Ausnutzung des verfügbaren Platzes auf der Lagerfläche 4 gewährleistet. Außerdem bilden die Fragmente 5 einen stabilen Verbund untereinander.

Die Figur 2 zeigt die kalottenförmige Lagerfläche 4 in einem Ausschnitt in größerem Detail. Hier ist zu erkennen, dass die Fragmente 5 unterschiedlich ausgebildet sind, also benachbarte Fragmente nicht dieselbe Form aufweisen, sondern unterschiedlich in ihrer äußeren Form gestaltet sind.

Jedes Fragment 5 weist eine Aufnahme 6 zur Aufnahme eines zu beschichtenden Brillenglases auf. Jede Aufnahme 6 umfasst einen Wendemechanismus, welcher einen Spannmechanismus 7 zur klemmenden Aufnahme der Brillengläser und ein Kipphebelgetriebe 10 zum Wenden der Aufnahme umfasst.

Der Spannmechanismus 7 ist als das Brillenglas umschließender Ring ausgebildet, welcher über zwei symmetrisch angeordnete Kniehebelmechanismen 8 mit entsprechend federnd gelagerten Stangen 9 in einfacher Weise in Anlage an die Brillengläser gebracht werden kann und wieder geöffnet werden kann. Durch die federnd gelagerten oder federnd ausgebildeten Stangen 9 wird der Kniehebelmechanismus 8, je nachdem in welche Richtung der Todpunkt des Kniehebelmechanismus überschritten ist, in eine geöffnete Stellung oder in eine geschlossene Stellung vorgespannt. Dies ermöglicht einen schnellen Wechsel der Brillengläser in der Aufnahme 6. Außerdem kann der Spannmechanismus 7 so ausgebildet sein, dass er lediglich durch Einstecken in die Aufnahme 6 bzw. das Fragment 5 oder das Kipphebelgetriebe 10 eingesetzt werden kann, so dass das Einspannen der Brillengläser außerhalb und unabhängig von der Aufnahme 6 in der kalottenförmigen Lagerfläche 4 vorgenommen werden kann.

Der Spannmechanismus 7 ist über das Kipphebelgetriebe 10 drehbar gelagert, so dass das Brillenglas nach dem Beschichten der ersten Seite in einfacher Weise gedreht werden kann.

Der Wendemechanismus ist dabei in einfacher Weise so ausgestaltet, dass das Wenden der Brillengläser automatisiert erfolgt. Zum Wenden des Spannmechanismus 7 sind das Kipphebelgetriebe 10 und der Spannmechanismus 7 über eine Drehachse mit dem Fragment 5 der Lagerfläche 4 drehbar verbunden.

Gemäß der gezeigten Ausführungsform wird das Kipphebelgetriebe 10 über einen Aktuator 11 aus einer Formgedächtnislegierung betätigt. Das Wirkprinzip ist schematisch in Figur 3 dargestellt. Der Aktuator 11 aus einer Formgedächtnislegierung kann durch Temperaturänderungen zu einer linearen Bewegung veranlasst werden, welche in der Figur 3 gestrichelt als Verlängerung des Aktuators 11 dargestellt ist. Dies ist jedoch rein schematisch und kann in vielfältiger unterschiedlicher Weise mit unterschiedlichen Formen des Aktuators realisiert werden.

Der Aktuator 11 ist über ein Drehgelenk 13 mit dem Kipphebel 12 des Kipphebelgetriebes 10 verbunden, so dass ein mit dem Kipphebel 12 verbundenes Getrieberad 14 um eine Drehachse 16 gedreht wird. Das Getrieberad 14 wirkt mit einem Getrieberad 15 mit kleinerem Durchmesser zusammen, so dass beispielsweise eine Winkeldrehung um 45° des Getrieberads 14 eine Winkeldrehung des Getrieberads 15 um 180° bewirkt. Das Getrieberad 15 ist auf einer Drehachse 17 gelagert, welche die Drehung des Spannmechanismus 7 bzw. der Aufnahme 6 bewirkt. Auf diese Weise kann durch den Aktuator 11 über das Kipphebelgetriebe 10 eine Drehung des Brillenglases bewirkt werden, wobei der Aktuator durch eine Temperaturänderung gesteuert wird. Durch eine Temperaturerhöhung kann bewirkt werden, dass sich der Aktuator 11 bzw. die Formgedächtnislegierung ausdehnt. Dadurch kann über das Kipphebelgetriebe 10 eine Drehung des Glases in der Aufnahme 6 um 180° bewirkt werden. Entsprechend kann, nachdem die Beschichtung auf der ersten Seite des Glases vollendet ist, in der Vakuumkammer die schematisch dargestellte Heizeinrichtung 18 betätigt werden, um die Temperatur in der Vakuumkammer auf die notwendige Schalttemperatur zu bringen, welche üblicherweise höher als die höchste auftretende Prozesstemperatur ist, und insbesondere mit einem Abstand von 10 Kelvin und mehr gewählt ist. Die schematisch dargestellte Heizeinrichtung 18 kann üblicherweise eine Strahlungsheizquelle sein, da in der Vakuumkammer aufgrund des dort herrschenden Vakuums die Wärmeleitung nicht oder nur uneffektiv möglich ist.

Da die Lagerfläche 4 des Gestells 3 mit einer Vielzahl von gleichartigen Aufnahmen 6 ausgestattet ist, welche alle so ausgebildet sind, dass sie bei der gleichen Schalttemperatur schalten, werden die Aufnahmen 6 bzw. die entsprechenden Gläser gleichzeitig automatisiert gewendet.

Vorzugsweise kann das Kipphebelgetriebe 10 einen Freilauf umfassen, so dass eine Drehung des Getrieberads 15 lediglich in eine Richtung möglich ist. Bei einer Rückbildung des Aktuators 11 bei einer Temperaturabsenkung erfolgt somit kein Zurückdrehen der Aufnahme 6 bzw. der Brillengläser. Vielmehr wird lediglich immer in eine Richtung gedreht.

Obwohl die vorliegende Erfindung anhand des Ausführungsbeispiels detailliert beschrieben worden ist, ist für den Fachmann selbstverständlich, dass die Erfindung nicht auf diese Ausführungsform beschränkt ist, sondern Abwandlungen oder Ergänzungen, insbesondere durch Weglassen einzelner Merkmale oder andersartige Kombination von Merkmalen, möglich sind, ohne den Schutzbereich der beigefügten Ansprüche zu verlassen.

## Patentansprüche

1. Vorrichtung zur Beschichtung von Glas in einer Vakuumkammer (1) mit einem Gestell (3) zur Lagerung einer Vielzahl von zu beschichtenden Gläsern, wobei das Gestell eine vorzugsweise gekrümmte Lagerfläche (4) mit einer Vielzahl von Aufnahmen (6) aufweist, in welchen die Gläser während der Beschichtung aufgenommen werden können, wobei die Lagerfläche in eine Vielzahl von ungleichmäßig unterteilten Fragmenten (5) unterteilt ist, wobei die Fragmente (5) mehreckig mit gekrümmten und/oder geraden Kanten ausgebildet sind,
**dadurch gekennzeichnet, dass**
die Fragmente (5) aneinander anliegend derart nebeneinander angeordnet sind, dass durch Vermeidung gerader Trennlinien über mehrere Fragmente (5) hinweg ein stabiler Verbund gegeben ist.

2. Vorrichtung nach Anspruch 1,
**dadurch gekennzeichnet, dass**
die Fragmente (5) austauschbar in dem Gestell (3) angeordnet sind.

3. Vorrichtung nach einem der vorhergehenden Ansprüche,
**dadurch gekennzeichnet, dass**
die Fragmente (5) einzeln austauschbar in dem Gestell (3) aufgenommen sind.

4. Vorrichtung nach einem der vorhergehenden Ansprüche,
**dadurch gekennzeichnet, dass**
jedes Fragment (5) eine Aufnahme (6) aufweist.

5. Vorrichtung nach einem der vorhergehenden Ansprüche,
**dadurch gekennzeichnet, dass**
die Fragmente (5) untereinander verbunden sind.

6. Vorrichtung nach einem der vorhergehenden Ansprüche,
**dadurch gekennzeichnet, dass**
die Fragmente (5) derart gebildet sind, dass für eine gegebene Lagerfläche eine maximale Anordnung von Aufnahmen (6), insbesondere mit den Zentren der Fragmente (5) in einer hexagonalen Wabenstruktur gegeben ist.

7. Vorrichtung nach einem der vorhergehenden Ansprüche,
**dadurch gekennzeichnet, dass**
die Aufnahme (6) für das Glas einen automatisierten Wendemechanismus (7,10) aufweist.

8. Vorrichtung nach Anspruch 7,
**dadurch gekennzeichnet, dass**
der Wendemechanismus für alle Aufnahmen (6) gleichzeitig schaltbar ist.

9. Vorrichtung nach Anspruch 7 oder 8,
**dadurch gekennzeichnet, dass**
der Wendemechanismus einen Aktuator (11) aufweist, der durch Temperaturänderung betätigbar ist.

10. Vorrichtung nach Anspruch 9,
**dadurch gekennzeichnet, dass**
der Aktuator (11) eine Formgedächtnislegierung umfasst.

11. Vorrichtung nach Anspruch 9 oder 10,
**dadurch gekennzeichnet, dass**
der Aktuator (11) in Form eines linear sich erstreckendes und verkürzendes Elements, insbesondere in der Art einer Zugfeder oder eines Hubzylinders ausgebildet ist.

12. Vorrichtung nach einem der Ansprüche 9 bis 11,
**dadurch gekennzeichnet, dass**
eine zentrale Heiz- und/oder Kühleinrichtung (18) der Vakuumkammer für die Betätigung der Aktuatoren (11) vorgesehen ist.

13. Vorrichtung nach Anspruch 12,
**dadurch gekennzeichnet, dass**
die zentrale Heiz- und/oder Kühleinrichtung (18) jeweils eine einzige Heiz- und/oder Kühlvorrichtung oder einige wenige in der Vakuumkammer verteilte Heiz- und/oder Kühlvorrichtungen umfasst.

14. Vorrichtung nach Anspruch 11,
**dadurch gekennzeichnet, dass**
der Aktuator (11) als selbständiges Antriebsmittel fungiert, insbesondere mit einem Kipphebelgetriebe (10) zusammenwirkt und/oder als Schaltelement ein Antriebsmittel, insbesondere ein Energie speicherndes Antriebsmittel, wie eine Feder, schaltet.

15. Vorrichtung nach Anspruch 14,
**dadurch gekennzeichnet, dass**
das Kipphebelgetriebe (10) eine Umsetzung der linearen Bewegung des Aktuators (11) in eine Drehbewegung der Aufnahme (6) bewirkt.

16. Vorrichtung nach Anspruch 15,
**dadurch gekennzeichnet, dass**
die linearen Bewegung des Aktuators (11) eine Drehbewegung des gelenkig mit dem Aktuator (11) verbundenen Kipphebels (12) bewirkt, wobei dessen Kippbewegung von dem Kipphebelgetriebe (10) in eine Drehbewegung der Aufnahme (6) umgesetzt wird.

17. Vorrichtung nach Anspruch 16,
**dadurch gekennzeichnet, dass**
die Kippbewegung einen kleineren Winkelbereich umfasst als die Drehbewegung, insbesondere eine 45° Kippbewegung in eine 180° Drehbewegung umsetzt.

18. Vorrichtung nach einem der Ansprüche 14 bis 17,
**dadurch gekennzeichnet, dass**
das Kipphebelgetriebe (10) einen Freilauf aufweist, der eine Bewegungsrichtung des Aktuators (11) in Leerlauf setzt.

19. Vorrichtung nach einem der Ansprüche 14 bis 18,
**dadurch gekennzeichnet, dass**
das Kipphebelgetriebe (10) zumindest teilweise gekapselt ist.

20. Vorrichtung nach einem der Ansprüche 14 bis 19,
**dadurch gekennzeichnet, dass**
das Kipphebelgetriebe (10) schmiermittelfrei ist und/oder die sich gegeneinander bewegenden Komponenten gegeneinander abrollen.

21. Vorrichtung nach einem der Ansprüche 14 bis 20,
**dadurch gekennzeichnet, dass**
das Kipphebelgetriebe (10) austauschbar an dem Fragment (5) oder der Aufnahme (6) angeordnet ist.

22. Vorrichtung nach einem der vorhergehenden Ansprüche,
**dadurch gekennzeichnet, dass**
die Aufnahme (6) einen Spannmechanismus (7) zum klemmenden Halten eines Glases aufweist.

23. Vorrichtung nach Anspruch 22,
**dadurch gekennzeichnet, dass**
der Spannmechanismus (7) in die Aufnahme (6) oder das Fragment (5) lösbar einsetzbar ist.

24. Verfahren zur Beschichtung von Glas in einer Vakuumkammer mit einer Vorrichtung nach einem der vorhergehenden Ansprüche,
**dadurch gekennzeichnet, dass**
ein Wendemechanismus (7,10) für das Glas vorgesehen ist, der temperaturabhängig geschaltet wird, wobei die Temperatur in der Vakuumkammer zum Wenden des Glases über eine Schalttemperatur angehoben wird.

25. Verfahren nach Anspruch 24,
**dadurch gekennzeichnet, dass**
die Wendemechanismen aller Aufnahmen (6) gleichzeitig geschaltet werden.

26. Verfahren nach Anspruch 24 oder 25,
**dadurch gekennzeichnet, dass**
die Schalttemperatur des Wendemechanismus höher als die höchste Prozesstemperatur, insbesondere gleich oder mehr als 10 K höher als die höchste Prozesstemperatur gewählt wird.

## Claims

1. Device for coating glass in a vacuum chamber (1) comprising a frame (3) for retaining a multiplicity of glasses to be coated, the frame having a preferably curved retaining surface (4) with a multiplicity of receptacles (6), in which the glasses can be held during the coating, the retaining surface being divided into a multiplicity of unequally divided fragments (5), the fragments (5) being formed polygonally with curved and/or straight edges, **characterized in that** the fragments (5) are arranged next to one another, lying against one another, in such a way that a stable assembly is obtained by avoiding straight separating lines extending over a number of fragments (5).

2. Device according to Claim 1, **characterized in that** the fragments (5) are arranged in the frame (3) in such a way that they can be exchanged.

3. Device according to one of the preceding claims, **characterized in that** the fragments (5) are held in the frame (3) in such a way that they can be individually exchanged.

4. Device according to one of the preceding claims, **characterized in that** each fragment (5) has a receptacle (6).

5. Device according to one of the preceding claims, **characterized in that** the fragments (5) are connected to one another.

6. Device according to one of the preceding claims, **characterized in that** the fragments (5) are formed in such a way that for a given retaining surface there is a maximum arrangement of receptacles (6), in particular with the centres of the fragments (5) in a hexagonal honeycomb structure.

7. Device according to one of the preceding claims, **characterized in that** the receptacle (6) for the glass has an automated turning mechanism (7, 10).

8. Device according to Claim 7, **characterized in that** the turning mechanism can be switched simultaneously for all the receptacles (6).

9. Device according to Claim 7 or 8, **characterized in that** the turning mechanism has an actuator (11), which can be actuated by a change in temperature.

10. Device according to Claim 9, **characterized in that** the actuator (11) comprises a shape-memory alloy.

11. Device according to Claim 9 or 10, **characterized in that** the actuator (11) takes the form of a linearly extending and retracting element, in particular in the manner of a tension spring or a lifting cylinder.

12. Device according to one of Claims 9 to 11, **characterized in that** a central heating and/or cooling unit (18) of the vacuum chamber is provided for the actuation of the actuators (11).

13. Device according to Claim 12, **characterized in that** the central heating and/or cooling unit (18) in each case comprises a single heating and/or cooling device or a small number of heating and/or cooling devices distributed in the vacuum chamber.

14. Device according to Claim 11, **characterized in that** the actuator (11) acts as an independent driving means, in particular interacts with a tilting lever mechanism (10), and/or, as a switching element, switches a driving means, in particular an energy-storing driving means, such as a spring.

15. Device according to Claim 14, **characterized in that** the tipping lever mechanism (10) brings about a conversion of the linear movement of the actuator (11) into a rotating movement of the receptacle (6).

16. Device according to Claim 15, **characterized in that** the linear movement of the actuator (11) brings about a rotating movement of the tilting lever (12), which is connected in an articulated manner to the actuator (11) and the tilting movement of which is converted into a rotating movement of the receptacle (6) by the tilting lever mechanism (10).

17. Device according to Claim 16, **characterized in that** the tilting movement comprises a smaller angular range than the rotating movement, in particular a 45° tilting movement converts into a 180° rotating movement.

18. Device according to one of Claims 14 to 17, **characterized in that** the tilting lever mechanism (10) has a freewheel, which neutralizes one direction of movement of the actuator (11).

19. Device according to one of Claims 14 to 18, **characterized in that** the tilting lever mechanism (10) is at least partially encapsulated.

20. Device according to one of Claims 14 to 19, **characterized in that** the tilting lever mechanism (10) is lubricant-free and/or the components that move with respect to one another roll against one another.

21. Device according to one of Claims 14 to 20, **characterized in that** the tilting lever mechanism (10) is arranged on the fragment (5) or the receptacle (6) in such a way that it can be exchanged.

22. Device according to one of the preceding claims, **characterized in that** the receptacle (6) has a clamping mechanism (7) for holding a glass in a clamping manner.

23. Device according to Claim 22, **characterized in that** the clamping mechanism (7) can be releasably inserted into the receptacle (6) or the fragment (5).

24. Method for coating glass in a vacuum chamber with a device according to one of the preceding claims, **characterized in that** a turning mechanism (7, 10) for the glass that is switched temperature-dependently is provided, the temperature in the vacuum chamber being raised beyond a switching temperature to turn the glass.

25. Method according to Claim 24, **characterized in that** the turning mechanisms of all the receptacles (6) are switched simultaneously.

26. Method according to Claim 24 or 25, **characterized in that** the switching temperature of the turning mechanism is chosen to be higher than the highest process temperature, in particular higher by 10 K or more than the highest process temperature.

## Revendications

1. Dispositif pour le revêtement de verre dans une chambre sous vide (1) avec un châssis (3) destiné à supporter une multiplicité de verres à revêtir, dans lequel le châssis présente une face de support de préférence courbée (4) avec une multiplicité de logements (6), dans lesquels les verres peuvent être logés pendant le revêtement, dans lequel la face de support est subdivisée en une multiplicité de fragments irrégulièrement divisés (5), dans lequel les fragments (5) sont de forme polygonale avec des côtés courbes et/ou droits, **caractérisé en ce que** les fragments (5) sont disposés les uns à côté des autres en contact les uns avec les autres, de telle manière que l'on obtienne un ensemble stable en évitant des lignes de séparation droites par-dessus plusieurs fragments (5).

2. Dispositif selon la revendication 1, **caractérisé en ce que** les fragments (5) sont disposés de façon échangeable dans le châssis (3).

3. Dispositif selon l'une quelconque des revendications précédentes, **caractérisé en ce que** les fragments (5) sont logés de façon échangeable individuellement dans le châssis (3).

4. Dispositif selon l'une quelconque des revendications précédentes, **caractérisé en ce que** chaque fragment (5) présente un logement (6).

5. Dispositif selon l'une quelconque des revendications précédentes, **caractérisé en ce que** les fragments (5) sont reliés entre eux.

6. Dispositif selon l'une quelconque des revendications précédentes, **caractérisé en ce que** les fragments (5) sont formés de telle manière que, pour une surface de support donnée, il existe un agencement maximal de logements (6), en particulier avec les centres des fragments (5) dans une structure hexagonale en nid d'abeilles.

7. Dispositif selon l'une quelconque des revendications précédentes, **caractérisé en ce que** le logement (6) pour le verre présente un mécanisme de retournement automatisé (7, 10).

8. Dispositif selon la revendication 7, **caractérisé en ce que** le mécanisme de retournement peut être commuté simultanément pour tous les logements (6).

9. Dispositif selon la revendication 7 ou 8, **caractérisé en ce que** le mécanisme de retournement présente un actionneur (11), qui peut être actionné par une variation de température.

10. Dispositif selon la revendication 9, **caractérisé en ce que** l'actionneur (11) comprend un alliage à mémoire de forme.

11. Dispositif selon la revendication 9 ou 10, **caractérisé en ce que** l'actionneur (11) est réalisé sous la forme d'un élément s'allongeant et se raccourcissant de manière linéaire, en particulier à la manière d'un ressort de traction ou d'un cylindre de levage.

12. Dispositif selon l'une quelconque des revendications 9 à 11, **caractérisé en ce qu'**il est prévu un dispositif central de chauffage et/ou de refroidissement (18) de la chambre sous vide pour l'actionnement des actionneurs (11).

13. Dispositif selon la revendication 12, **caractérisé en ce que** le dispositif central de chauffage et/ou de refroidissement (18) comprend respectivement un unique dispositif de chauffage et/ou de refroidissement ou quelques dispositifs de chauffage et/ou de refroidissement répartis en petit nombre dans la chambre sous vide.

14. Dispositif selon la revendication 11, **caractérisé en ce que** l'actionneur (11) fait office de moyen d'entraînement autonome, en particulier coopère avec un mécanisme à levier basculant (10) et/ou, comme élément de commutation, commute un moyen d'entraînement, en particulier un moyen d'entraînement accumulant l'énergie.

15. Dispositif selon la revendication 14, **caractérisé en ce que** le mécanisme à levier basculant (10) provoque une conversion du mouvement linéaire de l'actionneur (11) en un mouvement de rotation du logement (6).

16. Dispositif selon la revendication 15, **caractérisé en ce que** le mouvement linéaire de l'actionneur (11) provoque un mouvement de rotation du levier basculant (12) relié de manière articulée à l'actionneur (11), dans lequel le mouvement basculant de celui-ci est converti par le mécanisme à levier basculant (10) en un mouvement de rotation du logement (6).

17. Dispositif selon la revendication 16, **caractérisé en ce que** le mouvement basculant comprend une plus petite plage angulaire que le mouvement de rotation, en particulier un mouvement basculant de 45° dans un mouvement de rotation de 180°.

18. Dispositif selon l'une quelconque des revendications 14 à 17, **caractérisé en ce que** le mécanisme à levier basculant (10) présente une roue libre, qui met en marche à vide un sens de mouvement de l'actionneur (11).

19. Dispositif selon l'une quelconque des revendications 14 à 18, **caractérisé en ce que** le mécanisme à levier basculant (10) est au moins en partie encapsulé.

20. Dispositif selon l'une quelconque des revendications 14 à 19, **caractérisé en ce que** le mécanisme à levier basculant (10) est sans lubrifiant et/ou les composants se déplaçant l'un par rapport à l'autre roulent l'un contre l'autre.

21. Dispositif selon l'une quelconque des revendications 14 à 20, **caractérisé en ce que** le mécanisme à levier basculant (10) est disposé de façon échangeable sur le fragment (5) ou le logement (6).

22. Dispositif selon l'une quelconque des revendications précédentes, **caractérisé en ce que** le logement (6) comporte un mécanisme de serrage (7) pour le maintien serré d'un verre.

23. Dispositif selon la revendication 22, **caractérisé en ce que** le mécanisme de serrage (7) peut être inséré de façon amovible dans le logement (6) ou le fragment (5).

24. Procédé pour le revêtement de verre dans une chambre sous vide avec un dispositif selon l'une quelconque des revendications précédentes, **caractérisé en ce qu'**il est prévu un mécanisme de retournement (7, 10) pour le verre, qui est commuté en fonction de la température, dans lequel on élève la température dans la chambre sous vide au-dessus d'une température de commutation pour le retournement du verre.

25. Procédé selon la revendication 24, **caractérisé en ce que** les mécanismes de retournement de tous les logements (6) sont commutés simultanément.

26. Procédé selon la revendication 24 ou 25, **caractérisé en ce que** l'on choisit la température de commutation du mécanisme de retournement à un niveau plus élevé que la plus haute température du processus, en particulier à un niveau égal ou supérieur de plus de 10 K à la plus haute température du processus.
